# FASCICULE DE BREVET EUROPEEN

(11) **EP 4 113 220 B1**
(45) Date de publication et mention de la délivrance du brevet: **28.08.2024**
(21) Numéro de dépôt: 21183556.6
(22) Date de dépôt: 02.07.2021
(51) Int. Cl.: G04B 31/06, G04B 31/08, C30B 33/00, G04D 3/00

(54) **PROCÉDÉ DE TRAITEMENT DE SURFACE D'UNE PIERRE, NOTAMMENT POUR L'HORLOGERIE**
VERFAHREN ZUR OBERFLÄCHENBEHANDLUNG EINES STEINS, INSBESONDERE FÜR UHREN
METHOD FOR SURFACE TREATMENT OF A STONE, IN PARTICULAR FOR TIMEPIECES

(43) Date de publication de la demande: 04.01.2023
(73) Titulaire: Comadur SA, 2400 Le Locle (CH)
(72) Inventeur: VUILLE, Pierry, 2338 Les Emibois (CH); BOULMAY, Alexis, 25800 Valdahon (FR)
(74) Mandataire: ICB SA

(56) Documents cités:
- EP-A1- 3 389 078
- EP-A1- 3 556 911
- EP-A1- 3 783 445

## Description

### Domaine technique de l'invention

L'invention se rapporte à un procédé de traitement de surface d'une pierre d'horlogerie, notamment pour l'horlogerie.

### Arrière-plan technologique

Dans l'état de la technique de l'horlogerie, les mobiles tournants, tels que des balanciers, comportent généralement deux pivots dont les extrémités sont insérées dans des pierres pour pouvoir tourner. Généralement, on utilise des pierres de type rubis, ZᵣO₂ ou saphir, pour former des contre-pivots ou des éléments de guidage appelés coussinets. Ces contre-pivots et éléments de guidage sont destinés à entrer en contact avec les pivots afin de rendre ces derniers mobiles en rotation et ce, avec un frottement minimal. Ainsi, ils forment, par exemple, tout ou partie d'un palier de l'arbre du mobile monté en rotation. Les pierres servant d'élément de guidage en rotation d'un pivot ont, généralement, un trou traversant dans lequel le pivot est inséré pour prendre appui sur un contre-pivot.

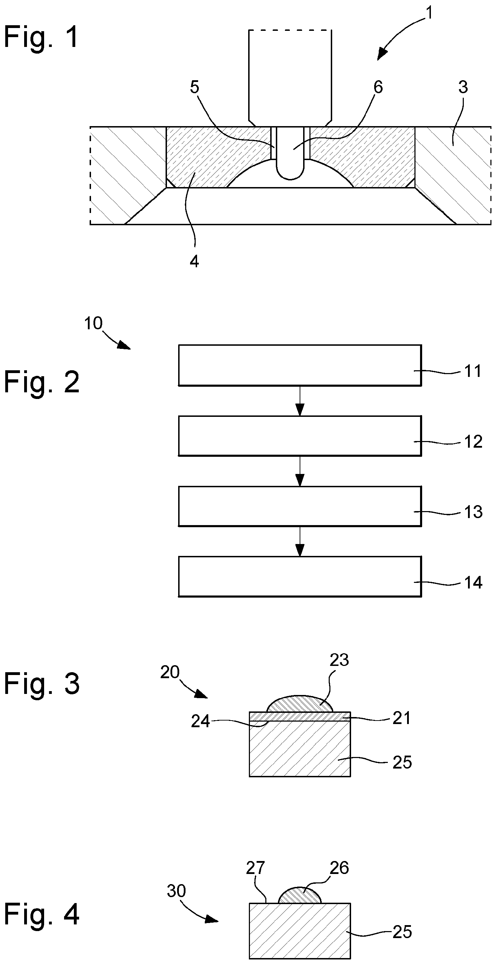

La figure 1 est un exemple de l'art antérieur, d'un ensemble 1 comprenant une pierre 2 munie d'un trou 3 et d'une creusure hémisphérique 4 formant l'entrée du trou 3. L'ensemble 1 comprend encore un pivot 7 configuré pour être inséré dans le trou 3 afin de permettre la rotation d'un élément mobile, non représenté sur la figure.

En principe, on utilise des pierres synthétiques dans les mouvements horlogers. On connait en particulier le procédé de type Verneuil pour fabriquer des pierres de type monocristallines. Il existe aussi les pierres de type poly-cristallines, que l'on fabrique par pressage d'un précurseur en vue de l'obtention d'un corps vert de la future pierre à partir d'un outil de pressage.

Une fois formées, les pierres sont généralement soumises à un procédé de dépôt d'un épilame sur la pierre. L'épilame est une couche mince permettant de modifier les caractéristiques physiques de la surface de la pierre.

L'état de surface est important pour le contact avec des liquides, notamment pour la lubrification de la pierre, par exemple avec un pivot. En effet, une goutte de liquide déposée sur la surface de la pierre, forme un angle de contact plus ou moins important selon l'état de surface. Plus l'angle est petit, plus la goutte s'étale sur la surface, et plus l'angle est grand, plus la goutte reste gonflée à la surface de la pierre. Par exemple, pour une pierre épilamée, l'angle d'une goutte d'huile de lubrification est d'environ 44°, alors que sans épilame, la goutte forme un angle inférieur, et est donc plus étalée. Généralement, on ne veut que la goutte s'étale, pour que la lubrification soit meilleure, par exemple entre la pierre et le pivot.

Cependant, l'inconvénient de la couche d'épilame est que son effet reste limité à un angle inférieur à 50°, même si elle augmente effectivement l'angle de contact. D'autre part, la couche d'épilame s'use avec le temps, car l'adhérence de la couche d'épilame sur la pierre n'est pas optimale. Par conséquent, l'usure de la couche d'épilame diminue l'adhérence de l'huile de lubrification. Finalement, il existe des documents tels que EP3556911A1 ou EP3389078A1, dans lesquels d'autres procédés de traitement de surface sont utilisés, comme le traitement par implantation ionique. Cependant, jusqu'à présent, ce type de traitement de surface était utilisé à d'autres fins.

### Résumé de l'invention

L'invention a pour but de remédier aux inconvénients précités, et vise à fournir une pierre dont l'angle de contact avec l'huile de lubrification est plus important, et qui résiste plus longtemps.

A cette fin, l'invention porte sur un procédé de traitement d'une pierre, notamment d'horlogerie, la pierre comprenant un corps définissant sa forme.

Le procédé est remarquable en ce qu'il comprend une étape d'implantation ionique à la surface du corps pour modifier la rugosité de ladite surface.

Grâce à l'implantation ionique, on augmente ou on diminue le relief de la surface de la pierre, qui modifie sa rugosité. Selon la taille des ions implantés, on obtient une rugosité différente, car les ions structurent la surface différemment. Certains ions augmentent la rugosité, tandis que d'autres ions diminuent la rugosité de la surface.

Ainsi, l'implantation ionique peut produire deux effets contraires particulièrement intéressants selon l'ion choisi pour être implanté. Avec certains ions, l'implantation ionique permet de diminuer l'angle de contact d'un liquide, tandis qu'avec d'autres ions, l'angle de contact avec un liquide augmente.

Par exemple, en diminuant l'angle de contact de la surface, on augmente l'adhérence d'une la couche d'épilame déposée sur cette surface implantée d'ions. Ainsi, on augmente la durée de vie de la couche d'épilame, qui s'use moins vite qu'une couche déposée sur une pierre sans implantation ionique.

D'autre part, en augmentant l'angle de contact de la surface de la pierre, on peut se passer de couche d'épilame, et disposer l'huile de lubrification directement sur la pierre. Ainsi, on simplifie le procédé de fabrication de la pierre, car on évite d'avoir à déposer une couche d'épilame, et on peut même obtenir des angles de contacts bien supérieurs à ceux obtenus avec une couche d'épilame.

Selon une forme de réalisation particulière de l'invention, le procédé comprend une étape de dépôt d'une couche d'épilame sur la surface de la pierre.

Selon une forme de réalisation particulière de l'invention, la couche d'épilame comprend du nitrure de chrome, de préférence en totalité.

Selon une forme de réalisation particulière de l'invention, l'étape de dépôt de la couche d'épilame est effectuée par PVD, PECVD.

Selon une forme de réalisation particulière de l'invention, les ions implantés à la surface réduisent l'angle de contact d'une goutte de liquide, l'angle de contact étant inférieur à 40° pour une goutte d'eau.

Selon une forme de réalisation particulière de l'invention, les ions implantés sont de l'hélium ou de l'argon.

Selon une forme de réalisation particulière de l'invention, les ions implantés à la surface du corps augmentent l'angle de contact d'une goutte de liquide, l'angle de contact étant supérieur à 50°, voire supérieur à 70° pour une goutte d'eau.

Selon une forme de réalisation particulière de l'invention, les ions implantés sont de l'azote.

Selon une forme de réalisation particulière de l'invention, l'étape d'implantation ionique est effectuée par résonance magnétique cyclotron électronique de type ECR.

Selon une forme de réalisation particulière de l'invention, l'étape d'implantation ionique est effectuée par plasma.

Selon une forme de réalisation particulière de l'invention, le corps de la pierre est préalablement formé lors d'une première étape par un procédé de type Verneuil pour une pierre monocristalline ou par un procédé de frittage pour une pierre polycristalline.

Selon une forme de réalisation particulière de l'invention, la pierre comprend de l'Al₂O₃ ou du ZᵣO₂, de préférence en totalité.

### Brève description des figures

D'autres particularités et avantages ressortiront clairement de la description qui en est faite ci-après, à titre indicatif et nullement limitatif, en référence aux dessins annexés, dans lesquels :
- la figure 1 est une représentation schématique d'un palier pour pivot selon un mode de réalisation connu de l'état de l'art ;
- la figure 2 est un schéma synoptique d'un procédé de réalisation d'une pierre selon l'invention ;
- la figure 3 est une représentation schématique d'une pierre obtenue grâce à un premier mode de réalisation du procédé selon l'invention ;
- la figure 4 est une représentation schématique d'une pierre obtenue grâce à un second mode de réalisation du procédé selon l'invention.

### Description détaillée de l'invention

Comme expliqué ci-dessus, l'invention se rapporte à un procédé de traitement de surface 10 d'une pierre susceptible de former un élément de guidage d'une pièce d'horlogerie, comme le montre la figure 1. La pierre est par exemple destinée à entrer en contact avec un pivot, appelé également tourillon, par exemple d'un axe de balancier, afin de rendre ce dernier mobile en rotation avec un frottement minimal. On comprend donc que la présente invention permet notamment de traiter une pierre pouvant former tout ou partie d'un palier d'un axe monté en rotation, tel que celui représenté sur la figure 1.

Selon le procédé 10 représenté sur la figure 2, on forme le corps de la pierre dans une première étape 11.

Pour une pierre de type polycristalline, on réalise un précurseur à partir d'un mélange d'au moins un matériau en poudre avec un liant. Ce matériau peut être, de manière non limitative et non exhaustive, de la céramique. Dans ce contexte, la poudre à base de céramique peut comporter au moins un oxyde métallique, un nitrure métallique ou un carbure métallique. A titre d'exemple, la poudre à base de céramique peut comporter de l'oxyde d'aluminium afin de former du saphir synthétique ou un mélange d'oxyde d'aluminium et d'oxyde de chrome afin de former du poly-rubis de type al₂O₃ ou de la céramique Zircone de type ZᵣO₂. De plus, le liant peut être de natures variées comme, par exemple, de types polymères ou de types organiques.

Une étape de pressage du précurseur est ensuite effectuée avec une matrice supérieure et une matrice inférieure d'un dispositif de pressage, afin de former un corps vert de la future pierre.

Ensuite on procède au frittage dudit corps vert afin de former le corps minéral de la future pierre dans ledit au moins un matériau. Le matériau peut être, ainsi que nous l'avons évoqué précédemment, de la céramique. Autrement dit, cette étape est destinée à fritter le corps vert afin de former un corps en céramique de la future pierre percée. Préférentiellement selon l'invention, l'étape de frittage peut comporter une pyrolyse, par exemple par déliantage thermique.

Un usinage du corps minéral est possible, afin par exemple de façonner la face supérieure et la face inférieure pour obtenir une épaisseur de pierre prédéfinie. L'usinage peut aussi consister à percer un trou traversant la pierre si besoin, et fonctionnaliser les surfaces du corps.

Un rodage et/ou un brossage et/ou un polissage du corps minéral permet d'obtenir une finition particulière. Cette finition permet de donner à la pierre un état de surface compatible avec son utilisation. Une telle étape de finition permet aussi l'ajustage des cotes finales et/ou le retrait d'arêtes et/ou la modification locale de la rugosité.

Pour une pierre monocristalline, le corps est formé par un procédé de type Verneuil. Un procédé de type Verneuil comprend une étape de fusion d'un matériau qui va se cristalliser au contact d'un monocristal germe. Le corindon (Al₂O₃) est généralement utilisé comme matériau de fusion. L'usinage et le rodage sont semblables au mode de réalisation de la pierre de type polycristalline.

Selon l'invention, une deuxième étape 12 du procédé 10 consiste à traiter au moins une partie de la surface du corps par implantation ionique. L'implantation ionique est une technologie permettant d'incorporer des ions dans un matériau.

Ainsi, elle permet de faire de la nanostructuration en modifiant le relief de la surface du corps. En effet, l'implantation d'ions dans la surface crée un relief, qui modifie la rugosité de la surface. Selon le type d'ions implantés, on obtient une rugosité différente, car les ions ont des tailles différentes, qui structurent la surface différemment. Certains ions augmentent la rugosité, tandis que d'autres ions diminuent la rugosité de la surface. En augmentant la rugosité, on augmente l'angle de contact, tandis qu'en diminuant la rugosité, on diminue l'angle de contact.

Il existe des installations pour un tel traitement, qui comprennent une source d'ions, un accélérateur de particules utilisant les propriétés électrostatiques pour créer un faisceau d'ions et une enceinte comportant le corps de la pierre pour recevoir les ions.

Dans une variante de réalisation préférée, l'implantation est opérée par immersion du corps de la pierre dans un plasma ionique. La pierre est plongée dans un plasma d'ions, par exemple par un procédé de résonance cyclotron électronique de type ECR.

Un premier mode de réalisation de la deuxième étape 12 du procédé 10 consiste à implanter des ions à la surface de la pierre, qui permettent de diminuer l'angle de contact d'un liquide sur ladite surface. L'angle de contact obtenu est de préférence inférieur à 40° pour une goutte d'eau. Ainsi, une telle surface permet d'améliorer l'adhérence d'une couche déposée sur la surface du corps, par exemple une couche d'épilame. De préférence, les ions implantés à la surface de la pierre sont des ions d'hélium ou d'argon, car ils diminuent l'angle de contact.

Dans un deuxième mode de réalisation de la deuxième étape 12, on implante dans la pierre des ions, qui permettent d'augmenter l'angle de contact d'une goutte de liquide sur la surface de la pierre. De préférence, les ions implantés à la surface de la pierre sont des ions d'azote. L'angle de contact est supérieur à 60°, voire supérieur à 70° pour une goutte d'eau. Ainsi, on évite d'avoir recours à une couche d'épilame.

De préférence, les ions sont implantés dans le corps à une profondeur pouvant aller jusqu'à 150nm.

Une troisième étape 13 du procédé 10 optionnelle selon le mode de réalisation choisi, et s'applique de préférence au premier mode de réalisation. La troisième étape 13 consiste à déposer une couche d'épilame sur la partie de la surface traitée par implantation ionique dans la deuxième étape. La couche d'épilame est de préférence une couche de nitrure de chrome. Une couche d'épilame est généralement déposée en phase vapeur par un procédé de type PVD ou PECVD. La couche d'épilame a de préférence une épaisseur de 0,003 à 0,006 µm.

Optionnellement, on peut effectuer une nanostructuration au laser de la couche d'épilame dans une quatrième étape 14. Ainsi, on peut sélectionner quelle partie de la surface de la pierre a une couche d'épilame.

La partie de pierre 20, représentée sur la figure 2, correspond à une pierre traitée selon le premier mode de réalisation. La pierre 20 comprend un corps 23 dont la surface 24 a été implantée d'ions réduisant l'angle de contact d'un liquide. La pierre 20 comporte en outre une couche d'épilame 21 déposée sur cette surface 24. Comme on le voit, une goutte de liquide déposée sur la couche d'épilame forme un angle de contact supérieur à 40° pour une goutte d'huile.

La partie de pierre 30, représentée sur la figure 3, correspond à une pierre traitée selon le deuxième mode de réalisation. La pierre 30 comprend un corps 25 dont la surface 27 a été implantée d'ions permettant d'augmenter l'angle de contact d'une goutte de liquide. Cette pierre n'a pas besoin de couche d'épilame, qui est absente sur la figure. Une goutte d'eau forme par exemple un angle de contact d'au moins 70° grâce à l'implantation ionique.

## Revendications

1. Procédé de traitement de surface (10) d'une pierre d'horlogerie de type monocristalline ou polycristalline (20, 30), la pierre (20, 30) comprenant un corps (23, 25) définissant sa forme, **caractérisé en ce qu'**il comprend une étape d'implantation ionique (12) à la surface (24, 27) d'au moins une partie dudit corps (23, 25) pour modifier la rugosité de ladite surface (24, 27).

2. Procédé selon la revendication 1, **caractérisé en ce qu'**il comprend une étape (13) de dépôt d'une couche d'épilame (21) sur la surface (24) de la pierre (20).

3. Procédé selon la revendication 1 ou 2, **caractérisé en ce que** la couche d'épilame (21) comprend du nitrure de chrome, de préférence en totalité.

4. Procédé selon la revendication 2 ou 3, **caractérisé en ce que** l'étape (13) de dépôt de la couche d'épilame (21) est effectuée par PVD, PECVD.

5. Procédé selon l'une, quelconque, des revendications précédentes, **caractérisé en ce que** les ions implantés à la surface (24) réduisent l'angle de contact d'une goutte de liquide (23), l'angle de contact étant inférieur à 40° pour une goutte d'eau.

6. Procédé selon l'une, quelconque, des revendications précédentes, **caractérisé en ce que** les ions implantés sont de l'hélium ou de l'argon.

7. Procédé selon la revendication 1, **caractérisé en ce que** les ions implantés à la surface (27) du corps (25) augmentent l'angle de contact d'une goutte de liquide (26), l'angle de contact étant supérieur à 50°, voire supérieur à 70° pour une goutte d'eau.

8. Procédé selon la revendication 7, **caractérisé en ce que** les ions implantés sont de l'azote.

9. Procédé selon l'une, quelconque, des revendications précédentes, **caractérisé en ce que** l'étape d'implantation ionique (12) est effectuée par résonance magnétique cyclotron électronique de type ECR.

10. Procédé selon l'une, quelconque, des revendications précédentes, **caractérisé en ce que** l'étape d'implantation ionique (12) est effectuée par plasma.

11. Procédé selon l'une, quelconque, des revendications précédentes, **caractérisé en ce que** le corps (23, 25) de la pierre (20, 30) est préalablement formé, lors d'une première étape (11), par un procédé de type Verneuil pour une pierre monocristalline ou par un procédé de frittage pour une pierre polycristalline.

12. Procédé selon l'une, quelconque, des revendications précédentes, **caractérisé en ce que** la pierre comprend de l'Al2O3 ou du ZrO2 , de préférence en totalité.

## Patentansprüche

1. Verfahren zur Oberflächenbehandlung (10) eines Uhrensteins (20, 30) vom monokristallinen oder polykristallinen Typ, wobei der Stein (20, 30) einen Körper (23, 25) umfasst, der seine Form definiert, **dadurch gekennzeichnet, dass** es einen Schritt der lonenimplantation (12) auf die Oberfläche (24, 27) von mindestens einem Teil des Körpers (23, 25) umfasst, um die Rauheit der Oberfläche (24, 27) zu modifizieren.

2. Verfahren nach Anspruch 1, **dadurch gekennzeichnet, dass** es einen Schritt (13) des Aufbringens einer Epilameschicht (21) auf die Oberfläche (24) des Steins (20) umfasst.

3. Verfahren nach Anspruch 1 oder 2, **dadurch gekennzeichnet, dass** die Epilameschicht (21) Chromnitrid umfasst, vorzugsweise vollständig.

4. Verfahren nach Anspruch 2 oder 3, **dadurch gekennzeichnet, dass** der Schritt (13) des Abscheidens der Epilameschicht (21) durch PVD, PECVD durchgeführt wird.

5. Verfahren nach einem beliebigen der vorhergehenden Ansprüche, **dadurch gekennzeichnet, dass** die auf der Oberfläche (24) implantierten Ionen den Kontaktwinkel eines Flüssigkeitstropfens (23) verringern, wobei der Kontaktwinkel bei einem Wassertropfen weniger als 40° beträgt.

6. Verfahren nach einem der vorhergehenden Ansprüche, **dadurch gekennzeichnet, dass** die implantierten Ionen Helium oder Argon sind.

7. Verfahren nach Anspruch 1, **dadurch gekennzeichnet, dass** die auf der Oberfläche (27) des Körpers (25) implantierten Ionen den Kontaktwinkel eines Flüssigkeitstropfens (26) vergrößern, wobei der Kontaktwinkel größer als 50° und bei einem Wassertropfen sogar größer als 70° ist.

8. Verfahren nach Anspruch 7, **dadurch gekennzeichnet, dass** es sich bei den implantierten Ionen um Stickstoff handelt.

9. Verfahren nach einem beliebigen der vorhergehenden Ansprüche, **dadurch gekennzeichnet, dass** der Schritt der lonenimplantation (12) mittels Elektronenzyklotron-Magnetresonanz vom ECR-Typ durchgeführt wird.

10. Verfahren nach einem beliebigen der vorhergehenden Ansprüche, **dadurch gekennzeichnet, dass** der Schritt der lonenimplantation (12) mittels Plasma durchgeführt wird.

11. Verfahren nach einem der vorhergehenden Ansprüche, **dadurch gekennzeichnet, dass** der Körper (23, 25) des Steins (20, 30) in einem ersten Schritt (11) durch ein Verneuil-Verfahren für einen einkristallinen Stein oder durch ein Sinterverfahren für einen polykristallinen Stein vorgeformt wird.

12. Verfahren nach einem beliebigen der vorhergehenden Ansprüche, **dadurch gekennzeichnet, dass** der Stein Al2O3 oder ZrO2, vorzugsweise vollständig, umfasst.

## Claims

1. Method (10) for the surface treatment of a watchmaking jewel of the monocrystalline or polycrystalline type (20, 30) the jewel (20, 30) comprising a body (23, 25) defining the shape thereof, **characterised in that** it comprises a step of ion implantation (12) on the surface (24, 27) of at least a part of said body (23, 25) to modify the roughness of said surface (24, 27).

2. Method according to claim 1, **characterised in that** it comprises a step (13) of depositing an epilame layer (21) on the surface (24) of the jewel (20).

3. Method according to claim 1 or 2, **characterised in that** the epilame layer (21) comprises chromium nitride, and is preferably made entirely thereof.

4. Method according to claim 2 or 3, **characterised in that** the step (13) of depositing the epilame layer (21) is carried out by PVD, PECVD.

5. Method according to any one of the preceding claims, **characterised in that** the ions implanted on the surface (24) reduce the contact angle of a drop of liquid (23), the contact angle being less than 40° for a drop of water.

6. Method according to any one of the preceding claims, **characterised in that** the implanted ions are helium or argon.

7. Method according to claim 1, **characterised in that** the ions implanted on the surface (27) of the body (25) increase the contact angle of a drop of liquid (26), the contact angle being greater than 50°, or even greater than 70°, for a drop of water.

8. Method according to claim 7, **characterised in that** the implanted ions are nitrogen.

9. Method according to any one of the preceding claims, **characterised in that** the ion implantation step (12) is carried out by ECR-type magnetic electron cyclotron resonance.

10. Method according to any one of the preceding claims, **characterised in that** the ion implantation step (12) is carried out using plasma.

11. Method according to any one of the preceding claims, **characterised in that** the body (23, 25) of the jewel (20, 30) is previously formed in a first step (11) by a Verneuil-type method for a monocrystalline jewel or by a sintering method for a polycrystalline jewel.

12. Method according to any one of the preceding claims, **characterised in that** the jewel comprises Al₂O₃ or ZrO₂, and is preferably made entirely thereof.
